# EUROPEAN PATENT APPLICATION

(11) **EP 4 429 127 A1**
(43) Date of publication of application: **11.09.2024**
(21) Application number: 22897201.4
(22) Date of filing: 28.07.2022
(51) Int. Cl.: H04B 10/032

(54) **OPTICAL BACKPLANE INTERCONNECTION APPARATUS AND COMMUNICATION DEVICE**

(30) Priority: 26.11.2021 CN 202111420485
(71) Applicant: Huawei Technologies Co., Ltd., Shenzhen, Guangdong 518129 (CN)
(72) Inventor: TENG, Shuangye, Shenzhen, Guangdong 518129 (CN); KONG, Fanhua, Shenzhen, Guangdong 518129 (CN); FAN, Huizhong, Shenzhen, Guangdong 518129 (CN); GONG, Tao, Shenzhen, Guangdong 518129 (CN)
(74) Representative: Maiwald GmbH
(86) International application number: PCT/CN2022/108647
(87) International publication number: WO 2023/093105

(57) **Abstract**

This application provides an optical backplane interconnection apparatus and a communication device. The optical backplane interconnection apparatus may include at least one optical backplane and at least one board. Each optical backplane is orthogonal to any board. A side surface of each optical backplane is disposed opposite to a side surface of any board. All the boards are located on a same side of any optical backplane. Each optical backplane is pluggablely connected to any board. In embodiments of this application, the optical backplane is connected to any board by using only one side surface, so that a position of the optical backplane is not limited by another component. In this way, the optical backplane can be pluggablely connected to the board. When the optical backplane is faulty, the optical backplane can be replaced separately without a need to replace an entire cabinet. In addition, each optical backplane is configured to be pluggablely connected to any board, so that the optical backplane can be replaced more flexibly and more easily.

## Description

### CROSS-REFERENCE TO RELATED APPLICATIONS

This application claims priority to Chinese Patent Application No. 202111420485.6, filed with the Chinese Patent Office on November 26, 2021 and entitled "OPTICAL BACKPLANE INTERCONNECTION APPARATUS AND COMMUNICATION DEVICE", which is incorporated herein by reference in its entirety.

### TECHNICAL FIELD

This application relates to the field of information communication technologies, and in particular, to an optical backplane interconnection apparatus and a communication device.

### BACKGROUND

A backplane is an important component of a communication device. The backplane is usually mounted on a rear surface or at a middle position of a cabinet and can provide a signal connection and physical support for a board, a module, or the like. The backplane plays an important role in a system capacity, a heat dissipation channel, performance maintenance, and the like of the communication device. The backplane can be classified into an electrical backplane and an optical backplane.

The electrical backplane usually includes components such as a printed circuit board, a connector, and a guide pin. Because component parts of the electrical backplane have high reliability and a low failure rate, and carry small quantity of services, the electrical backplane is usually fastened to a subrack. In other words, an unreplaceable solution may be used for the electrical backplane.

The optical backplane usually includes an optical fiber, an optical connector, a support structure member, and a guide pin. Reliability and a failure rate of component parts of the optical backplane are comparable to those of the electrical backplane. However, because the optical backplane carries a large quantity of services, and an end face of the optical fiber is sensitive to dust, in a case of high transmission power, an unreplaceable solution is used for the optical backplane. A signal transmission requirement cannot be met. However, in a conventional technology, because a position of the optical backplane is limited by another component, the optical backplane needs to be fastened to the subrack. As a result, the optical backplane cannot be replaced. If a channel in the optical backplane is damaged, service transmission effect is affected, and the entire cabinet may be replaced.

### SUMMARY

Embodiments of this application provide an optical backplane interconnection apparatus and a communication device, to resolve a problem that an optical backplane cannot be replaced in a conventional technology.

According to a first aspect, an embodiment of this application provides an optical backplane interconnection apparatus. The optical backplane interconnection apparatus may include at least one optical backplane and at least one board. Each optical backplane is orthogonal to any board. A side surface of each optical backplane is disposed opposite to a side surface of any board. All the boards are located on a same side of any optical backplane. Each optical backplane is pluggablely connected to any board.

In the optical backplane interconnection apparatus provided in this embodiment of this application, each optical backplane is disposed to be orthogonal to any board, a side surface of each optical backplane is disposed opposite to a side surface of any board, and all the boards are located on a same side of any optical backplane. In other words, the optical backplane is connected to any board by using only one side surface, so that a position of the optical backplane is not limited by another component. In this way, the optical backplane can be pluggablely connected to the board. When the optical backplane is faulty, the optical backplane can be replaced separately without a need to replace an entire cabinet. In addition, each optical backplane is configured to be pluggablely connected to any board, so that the optical backplane can be replaced more flexibly and more easily.

The board in this embodiment of this application may be any board that can transmit an optical signal. For example, the board may be a service processing board or a cross-connect board. For example, the service processing board may be a line card (Line Card, LC) for accessing and processing a service.

In some embodiments of this application, the optical backplane interconnection apparatus may include a plurality of boards arranged in a first direction. The first direction is a direction perpendicular to the boards. The boards in the optical backplane interconnection apparatus are disposed in parallel, to facilitate interconnection between the boards and the optical backplane. Optionally, the optical backplane may be connected to at least two boards. In this way, the optical backplane transmits an optical signal, so that the optical signal can be transmitted between the at least two boards. Optionally, the plurality of boards in the optical backplane interconnection apparatus may all be service processing boards, or the plurality of boards in the optical backplane interconnection apparatus may all be cross-connect boards, or the plurality of boards in the optical backplane interconnection apparatus may include both service processing boards and cross-connect boards.

In some other embodiments of this application, the optical backplane interconnection apparatus may include a plurality of optical backplanes arranged in a second direction. The second direction is a direction perpendicular to the optical backplanes. The optical backplanes in the optical backplane interconnection apparatus are disposed in parallel, to facilitate interconnection between the optical backplanes and the boards. Optionally, each optical backplane may be connected to any board. In this way, an optical signal can be transmitted between any two boards by using the optical backplanes.

In addition, the plurality of optical backplanes are disposed in the optical backplane interconnection apparatus, to implement a redundancy protection function. Specifically, at least one optical backplane may be used as a working backplane, and the remaining optical backplanes may be used as redundant backplanes. When the working backplane works normally, the redundant backplanes may be in a standby state. When the working backplane is faulty, the redundant backplanes may be controlled to switch from the standby state to a working state, to replace a function of the redundant backplane. This ensures that the optical backplane interconnection apparatus can run normally. In addition, the redundant backplanes are disposed, so that when the working backplane is faulty, the optical backplane can be replaced in an existing network without interrupting a service.

During specific implementation, a first optical connector is disposed on a side that is of each optical backplane and that is close to the board. A second optical connector is disposed on a surface of each board. Each optical backplane and any board implement an optical signal connection through the first optical connector and the second optical connector. Optionally, the first optical connector (or the second optical connector) may be various types of optical connectors such as an MT optical fiber connector, a multi-core multi-channel plug-in (MPO) optical fiber connector, or an LC-type optical fiber connector.

In this embodiment of this application, the first optical connector may be fastened to a side surface of the side that is of the optical backplane and that is close to the board, or the first optical connector may be disposed at an edge that is of a surface of the optical backplane and that is close to the board. A position of the first optical connector may be determined based on an actual requirement. This is not limited herein. In addition, the optical backplane may be connected to the board through two first optical connectors and two second optical connectors, or the optical backplane may be connected to the board through one first optical connector and one second optical connector. During specific implementation, quantities of first optical connectors and second optical connectors between the optical backplane and the board may be set based on an actual requirement. This is not limited herein.

In a possible implementation, the board is a service processing board. The optical backplane interconnection apparatus may further include at least one cross-connect board. Each cross-connect board is located on a side that is of any board and that faces the optical backplane, and each cross-connect board is orthogonal to any board. Each cross-connect board is pluggablely connected to any board. In other words, the cross-connect board and the optical backplane are located on a same side of the board, and the cross-connect board and the optical backplane are disposed in parallel. In this way, the optical backplane interconnection apparatus can process an electrical service while processing an optical service, to implement an optical-electrical integrated architecture. In addition, the board may be connected to the cross-connect board and the optical backplane on a same side surface, so that positions of various connectors on the board can be conveniently determined, and the optical backplane or cross-connect board can be easily replaced.

During specific implementation, the cross-connect board may receive an electrical-layer service transmitted by the board, and perform cross scheduling on the received electrical-layer service. In this embodiment of this application, the optical backplane and the cross-connect board are disposed in the optical backplane interconnection apparatus, so that the optical backplane interconnection apparatus can have functions of processing the optical service and the electrical service.

Optionally, in the optical backplane interconnection apparatus in this embodiment of this application, there may be one or more cross-connect boards. A quantity of cross-connect boards may be set based on an actual requirement. This is not limited herein.

In a possible implementation, the optical backplane interconnection apparatus may include a plurality of cross-connect boards. The plurality of cross-connect boards in the optical backplane interconnection apparatus are distributed on two sides of the at least one optical backplane. In other words, the optical backplane may be located at a middle position. Optionally, a quantity of cross-connect boards in the optical backplane interconnection apparatus may be an even number. The cross-connect boards may be symmetrically distributed on two sides of the optical backplane in the optical backplane interconnection apparatus. Alternatively, the plurality of cross-connect boards in the optical backplane interconnection apparatus may be distributed on a same side of the at least one optical backplane.

During specific implementation, a first electrical connector is disposed on a side that is of each cross-connect board and that is close to the board. A second electrical connector is disposed on a surface of each board. Each cross-connect board and any board implement an electrical signal connection through the first electrical connector and the second electrical connector. To facilitate a pluggable connection between the cross-connect board and the board, a spring plate may be disposed on the first electrical connector, and a contact matching the spring plate may be disposed on the second electrical connector, or a contact may be disposed on the first electrical connector, and a spring plate matching the contact may be disposed on the second electrical connector. In this way, the first electrical connector can be connected to the second electrical connector by using the contact and the spring plate. Certainly, the first electrical connector may alternatively be connected to the second electrical connector in another manner. This is not limited herein.

Optionally, the first electrical connector may be fastened to an edge that is of a surface of the cross-connect board and that is close to the board, or the first electrical connector may be disposed on a side surface of a side that is of the cross-connect board and that is close to the board. A position of the first electrical connector may be determined based on an actual requirement. This is not limited herein.

In a possible implementation, an electrical signal transmission module may be integrated into the optical backplane. A first optical connector and a third electrical connector are disposed on a side that is of each optical backplane and that is close to the board. A second optical connector and a second electrical connector are disposed on a surface of each board. The optical backplane and the board implement an optical signal connection through the first optical connector and the second optical connector. The optical backplane and the board implement an electrical signal connection through the third electrical connector and the second electrical connector. In this embodiment of this application, the electrical signal transmission module is integrated into the optical backplane, and an optical connector and an electrical connector are respectively disposed on the optical backplane and a service transmission board, so that the optical backplane integrates functions of transmitting an optical signal and an electrical signal. This can omit the cross-connect board in the optical backplane interconnection apparatus and reduce space occupied by the optical backplane interconnection apparatus. In addition, because the cross-connect board is omitted, a small quantity of components may be disposed on a side surface of the board. This can increase an air amount and help improve heat dissipation effect of each component in a communication device.

In a possible implementation, in each board, the second optical connector and the second electrical connector are respectively located on different surfaces of the board. In this way, space of an upper surface and a lower surface of the board can be fully used, and positions of the corresponding first optical connector and the corresponding third electrical connector on the optical backplane are more easily determined. This facilitates a pluggable connection between the optical backplane and the board. Certainly, when space of the optical backplane and space of the board are sufficient, the second optical connector and the second electrical connector may alternatively be disposed on a same surface of the board, that is, both are disposed on the upper surface or the lower surface of the board.

In a possible implementation, the optical backplane interconnection apparatus may include the plurality of boards, forming at least one board group. Each board group includes two boards, which are respectively a first board and a second board. In each board group, the first board and the second board are disposed side by side in the first direction. The first board is connected to the optical backplane at a position close to the second board. The second board is connected to the optical backplane at a position close to the first board. The first direction is the direction perpendicular to the boards. In this embodiment of this application, the first board and the second board are disposed side by side in the first direction, and both the first board and the second board are connected to the optical backplane at a position close to the middle, so that a quantity of boards connected to the optical backplane can be increased, and a quantity of slots of the optical backplane can be increased.

In each board group, the first board is provided with a second optical connector at the position close to the second board, and the second board is provided with a second optical connector at the position close to the first board. The optical backplane is provided with two first optical connectors at a position corresponding to each board group. One first optical connector is connected to the second optical connector of the first board. The other first optical connector is connected to the second optical connector of the second board.

The optical backplane interconnection apparatus in this embodiment of this application may be used in a communication device. Usually, a fan may be disposed in the communication device, to reduce temperature of each component in the communication device. Second optical connectors in the board group are concentrated at a middle position, so that first optical connectors on the optical backplane can also be concentrated. In this way, a width of the optical backplane in the first direction can be narrow, and space occupied by the optical backplane is reduced. Therefore, the optical backplane does not block an air duct. In this way, an air amount can be increased, and heat dissipation effect of each component in the communication device is good.

During specific implementation, in each board group, structures of the first board and the second board may be the same. For example, lines or modules in the first board and the second board may be disposed at a same position, and second optical connectors on surfaces of the first board and the second board may be disposed at a same position. In this way, the first board and the second board can share an accessory, and accessory processing costs can be reduced. When the board in each board group is connected to the optical backplane, the first board may be inserted in an upward manner, and the second board may be inserted in an inverse manner. That the first board is inserted in an upward manner may be understood as that the second optical connector connected to the optical backplane is disposed on an upper surface of the first board. That the second board is inserted in an inverse manner may be understood as that the second optical connector connected to the optical backplane is disposed on a lower surface of the second board.

In a possible implementation, the board is a service processing board. The optical backplane interconnection apparatus may further include at least two cross-connect boards, which are grouped into a first cross-connect board group and a second cross-connect board group. The first cross-connect board group includes at least one cross-connect board, and the second cross-connect board group includes at least one cross-connect board. Each cross-connect board is located on a side that is of the board and that faces the optical backplane, and each cross-connect board is orthogonal to any board. The first cross-connect board group and the second cross-connect board group are respectively located on two sides of the optical backplane. In each board group, the first board is pluggablely connected to the cross-connect board in the first cross-connect board group, and the second board is pluggablely connected to the cross-connect board in the second cross-connect board group.

In other words, each cross-connect board and the optical backplane in the optical backplane interconnection apparatus are located on a same side of the board, and each cross-connect board and the optical backplane are disposed in parallel, so that the board can be connected to each cross-connect board and the optical backplane on the same side. In this way, positions of various connectors on the board can be conveniently determined, and the optical backplane or the cross-connect board can be easily replaced. During specific implementation, the cross-connect board may receive an electrical-layer service transmitted by the board, and perform cross scheduling on the received electrical-layer service. In this embodiment of this application, the optical backplane and the cross-connect board are disposed in the optical backplane interconnection apparatus, so that the optical backplane interconnection apparatus can have functions of processing the optical service and the electrical service.

In some embodiments of this application, the optical backplane interconnection apparatus may further include an electrical backplane located between the board and the optical backplane. Each cross-connect board is located on a side that is of the electrical backplane and that is away from the board. The electrical backplane is pluggablely connected to the first board and the second board in each board group. The electrical backplane is pluggablely connected to each cross-connect board in the first cross-connect board group, and the electrical backplane is pluggablely connected to each cross-connect board in the second cross-connect board group. In this embodiment of this application, the electrical backplane is disposed, a surface of one side of the electrical backplane is connected to the first board and the second board, and a surface of the other side of the electrical backplane is connected to each cross-connect board in the first cross-connect board group and the second cross-connect board group, so that each cross-connect board in the first cross-connect board group can be electrically connected to each cross-connect board in the second cross-connect board group. In this way, an electrical signal can be transmitted between any two cross-connect boards in the first cross-connect board group and the second cross-connect board group.

During specific implementation, the electrical backplane is provided with a plurality of openings respectively corresponding to positions of first optical connectors on the optical backplane. The first optical connector passes through the opening at a corresponding position and is connected to the second optical connector. The electrical backplane is provided with the plurality of openings, so that each first optical connector on the optical backplane can be connected to the second optical connector after passing through the opening. In this way, the electrical backplane can be disposed at a position between the optical backplane and the board, and space in the optical backplane interconnection apparatus can be appropriately used. In addition, the electrical backplane does not affect a position of the optical backplane. This ensures that the optical backplane can be pluggablely connected to the board.

In a possible implementation, a first electrical connector is disposed on a side that is of each cross-connect board and that is close to the board. A second electrical connector is disposed on a surface of each board. A fourth electrical connector is disposed on a side that is of the electrical backplane and that is close to the cross-connect board. A fifth electrical connector is disposed on a side that is of the electrical backplane and that is close to the board. The electrical backplane and the cross-connect board implement an electrical signal connection through the first electrical connector and the fourth electrical connector. The electrical backplane and the board implement an electrical signal connection through the second electrical connector and the fifth electrical connector.

To facilitate a pluggable connection between the cross-connect board and the electrical backplane, a spring plate may be disposed on the first electrical connector, and a contact matching the spring plate may be disposed on the fourth electrical connector, or a contact may be disposed on the first electrical connector, and a spring plate matching the contact may be disposed on the fourth electrical connector. In this way, the first electrical connector can be connected to the fourth electrical connector by using the spring plate and the contact. Certainly, the first electrical connector may alternatively be connected to the fourth electrical connector in another manner. This is not limited herein.

To facilitate a pluggable connection between the board and the electrical backplane, a spring plate may be disposed on the second electrical connector, and a contact matching the spring plate may be disposed on the fifth electrical connector, or a contact may be disposed on the second electrical connector, and a spring plate matching the contact may be disposed on the fifth electrical connector. In this way, the second electrical connector can be connected to the fifth electrical connector by using the spring plate and the contact. Certainly, the second electrical connector may alternatively be connected to the fifth electrical connector in another manner. This is not limited herein.

In a possible implementation, the optical backplane interconnection apparatus may further include a subrack. The subrack is provided with a slot rail. The optical backplane is provided with a sliding rail matching the slot rail. In this way, the optical backplane can be conveniently inserted into the subrack to be connected to the board, and the optical backplane can be easily removed from the subrack. To facilitate removal of the optical backplane, a pull ring may be disposed on a side surface of the optical backplane. During specific implementation, a wrench or another component may also be used to replace the pull ring.

In addition, the optical backplane interconnection apparatus may further include at least one fastener. The fastener is configured to detachably fasten the optical backplane to the subrack. Optionally, the optical backplane may be provided with a through hole. The fastener may pass through the optical backplane and be fastened to the subrack, so that the optical backplane is fastened to the subrack, and the optical backplane is prevented from falling off in a processing or transportation process. When the optical backplane needs to be replaced, the fastener may be detached, so that the optical backplane can be smoothly removed. This ensures that the optical backplane can be smoothly replaced. For example, the fastener may be a captive screw, a screw rod, or the like.

According to a second aspect, an embodiment of this application further provides a communication device. The communication device may include any one of the foregoing optical backplane interconnection apparatuses and a housing. The communication device may be an optical communication device, a router, a switch, a server, or the like. In the optical backplane interconnection apparatus, the optical backplane is pluggablely connected to the board. Therefore, when the optical backplane is faulty, the optical backplane can be replaced separately without a need to replace an entire cabinet. The optical backplane interconnection apparatus has a flexible structure and high reliability. Therefore, the communication device including the optical backplane interconnection apparatus also has a flexible structure and high reliability.

### BRIEF DESCRIPTION OF DRAWINGS

FIG. 1 is a schematic diagram of a three-dimensional structure of an optical backplane interconnection apparatus according to an embodiment of this application;
FIG. 2 is a top view of the schematic diagram of a three-dimensional structure shown in FIG. 1;
FIG. 3 is a schematic diagram of another three-dimensional structure of an optical backplane interconnection apparatus according to an embodiment of this application;
FIG. 4 is a top view of a schematic diagram of a three-dimensional structure shown in FIG. 3;
FIG. 5 is a schematic diagram of another three-dimensional structure of an optical backplane interconnection apparatus according to an embodiment of this application;
FIG. 6 is a top view of a schematic diagram of a three-dimensional structure shown in FIG. 5;
FIG. 7 is a schematic diagram of another three-dimensional structure of an optical backplane interconnection apparatus according to an embodiment of this application;
FIG. 8 is a top view of the schematic diagram of a three-dimensional structure shown in FIG. 7;
FIG. 9 is a schematic diagram of another three-dimensional structure of an optical backplane interconnection apparatus according to an embodiment of this application;
FIG. 10 is a top view of the schematic diagram of a three-dimensional structure shown in FIG. 9;
FIG. 11 is a schematic diagram of another three-dimensional structure of an optical backplane interconnection apparatus according to an embodiment of this application;
FIG. 12 is a top view of the schematic diagram of a three-dimensional structure shown in FIG. 11;
FIG. 13 is a schematic diagram of a top view of a structure of an optical backplane interconnection apparatus according to an embodiment of this application;
FIG. 14 is a schematic diagram of a planar structure of an electrical backplane according to an embodiment of this application; and
FIG. 15 is a schematic diagram of a three-dimensional structure of an optical backplane according to an embodiment of this application.

Reference numerals:
11: optical backplane; 12: board; 12M: board group; 12a: first board; 12b: second board; 13: first optical connector; 14: second optical connector; 15: cross-connect board; 15M: first cross-connect board group; 15N: second cross-connect board group; 16: first electrical connector; 17: second electrical connector; 18: third electrical connector; 19: electrical backplane; 20: fourth electrical connector; 21: fifth electrical connector; 22: sliding rail; 23: fastener; 24: pull ring; F: fan; U: opening.

### DESCRIPTION OF EMBODIMENTS

To make objectives, technical solutions, and advantages of this application clearer, the following further describes this application in detail with reference to the accompanying drawings.

It should be noted that same reference numerals in the accompanying drawings of this application indicate same or similar structures. Therefore, repeated descriptions thereof are omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

To resolve a problem that an optical backplane cannot be replaced in a conventional technology, embodiments of this application provide an optical backplane interconnection apparatus and a communication device. The optical backplane interconnection apparatus may be used in various types of communication devices. For example, the communication device may be an optical communication device, a router, a switch, a server, or the like. Certainly, the optical backplane interconnection apparatus may alternatively be used in another type of communication device. This is not limited herein.

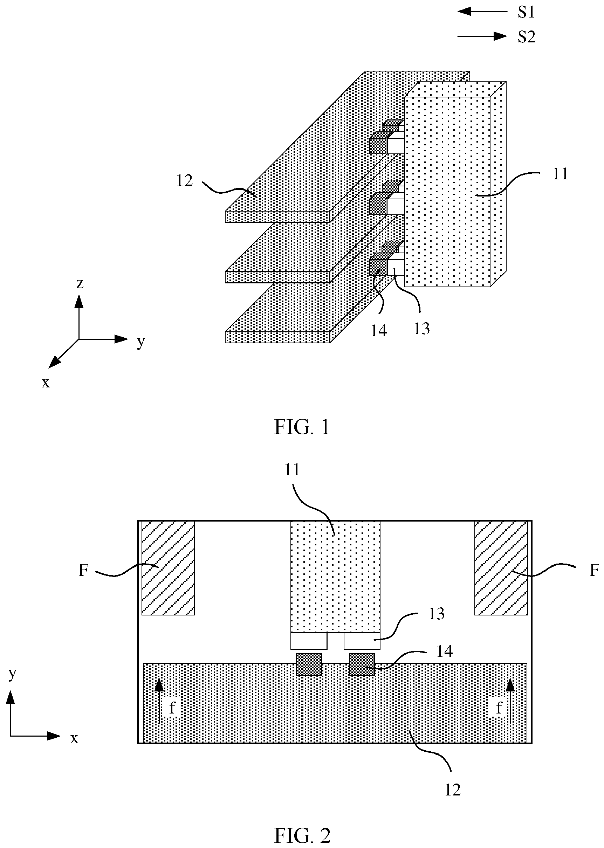

FIG. 1 is a schematic diagram of a three-dimensional structure of an optical backplane interconnection apparatus according to an embodiment of this application. FIG. 2 is a top view of the schematic diagram of a three-dimensional structure shown in FIG. 1. With reference to FIG. 1 and FIG. 2, the optical backplane interconnection apparatus provided in this embodiment of this application may include at least one optical backplane 11 and at least one board 12. In FIG. 1, an example in which the optical backplane interconnection apparatus includes one optical backplane 11 and three boards 12 is used for illustration. During specific implementation, quantities of optical backplanes 11 and boards 12 may be set based on a requirement. This is not limited herein. Each optical backplane 11 is orthogonal to any board 12. A side surface of each optical backplane 11 is disposed opposite to a side surface of any board 12. All the boards 12 are located on a same side of any optical backplane 11. Each optical backplane 11 is pluggablely connected to any board 12.

In the optical backplane interconnection apparatus provided in this embodiment of this application, each optical backplane is disposed to be orthogonal to any board, a side surface of each optical backplane is disposed opposite to a side surface of any board, and all the boards are located on a same side of any optical backplane. In other words, the optical backplane is connected to any board by using only one side surface, so that a position of the optical backplane is not limited by another component. In this way, the optical backplane can be pluggablely connected to the board. When the optical backplane is faulty, the optical backplane can be replaced separately without a need to replace an entire cabinet. In addition, each optical backplane is configured to be pluggablely connected to any board, so that the optical backplane can be replaced more flexibly and more easily.

To more clearly illustrate an orientation of each component in the optical backplane interconnection apparatus, an xyz coordinate system is identified in FIG. 1 and FIG. 2. Still refer to FIG. 1 and FIG. 2. When each board 12 in the optical backplane interconnection apparatus is parallel to an xy plane, the optical backplane 11 may be disposed to be parallel to a yz plane, so that the optical backplane 11 is orthogonal to the board 12. In addition, because all the boards 12 are located on the same side of the optical backplane 11, and a side surface of the optical backplane 11 faces each board 12, a position of the optical backplane 11 is not limited by another component. During specific implementation, the optical backplane 11 may be mounted based on a direction of an arrow S 1 in the figure. When the optical backplane 11 needs to be replaced, the optical backplane 11 may be detached based on a direction of S2 in the figure. In FIG. 1, an example in which each board 12 is located on a left side of the optical backplane 11, the boards 12 are horizontally placed, and the optical backplane 11 is vertically placed is used for illustration. During specific implementation, positions of the optical backplane 11 and the boards 12 may be determined based on an actual requirement. This is not limited herein.

The board 12 in this embodiment of this application may be any board that can transmit an optical signal. For example, the board may be a service processing board or a cross-connect board. For example, the board 12 may be a line card (Line Card, LC) for accessing and processing a service.

In some embodiments of this application, as shown in FIG. 1 and FIG. 2, the optical backplane interconnection apparatus may include a plurality of boards 12 arranged in a first direction (for example, a direction shown by an arrow z in the figure). The first direction is a direction perpendicular to the boards 12. The boards 12 in the optical backplane interconnection apparatus are disposed in parallel, to facilitate interconnection between the boards 12 and the optical backplane 11. Optionally, the optical backplane 11 may be connected to at least two boards 12. In this way, the optical backplane 11 transmits an optical signal, so that the optical signal can be transmitted between the at least two boards 12. Optionally, the plurality of boards 12 in the optical backplane interconnection apparatus may all be service processing boards, or the plurality of boards 12 in the optical backplane interconnection apparatus may all be cross-connect boards, or the plurality of boards 12 in the optical backplane interconnection apparatus may include both service processing boards and cross-connect boards.

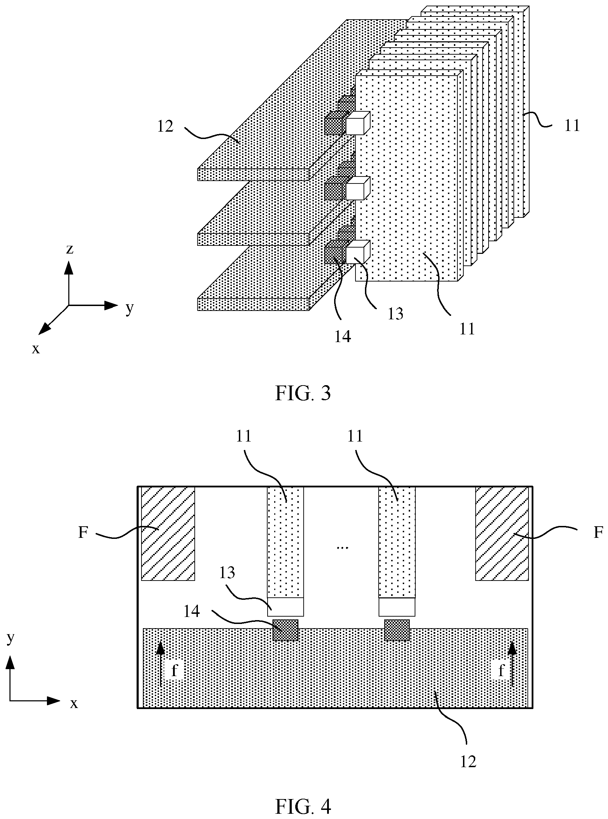

FIG. 3 is a schematic diagram of another three-dimensional structure of an optical backplane interconnection apparatus according to an embodiment of this application. FIG. 4 is a top view of the schematic diagram of a three-dimensional structure shown in FIG. 3. With reference to FIG. 3 and FIG. 4, in some other embodiments of this application, the optical backplane interconnection apparatus may include a plurality of optical backplanes 11 arranged in a second direction (for example, a direction shown by an arrow X in the figure). The second direction is a direction perpendicular to the optical backplanes 11. The optical backplanes 11 in the optical backplane interconnection apparatus are disposed in parallel, to facilitate interconnection between the optical backplanes 11 and the boards 12. Optionally, each optical backplane 11 may be connected to any board 12. In this way, an optical signal can be transmitted between any two boards 12 by using the optical backplanes 11.

In addition, the plurality of optical backplanes 11 are disposed in the optical backplane interconnection apparatus, to implement a redundancy protection function. Specifically, at least one optical backplane 11 may be used as a working backplane, and the remaining optical backplanes 11 may be used as redundant backplanes. When the working backplane works normally, the redundant backplanes may be in a standby state. When the working backplane is faulty, the redundant backplanes may be controlled to switch from the standby state to a working state, to replace a function of the redundant backplane. This ensures that the optical backplane interconnection apparatus can run normally. In addition, the redundant backplanes are disposed, so that when the working backplane is faulty, the optical backplane can be replaced in an existing network without interrupting a service.

During specific implementation, as shown in FIG. 1 and FIG. 2, a first optical connector 13 is disposed on a side that is of each optical backplane 11 and that is close to the board 12. A second optical connector 14 is disposed on a surface of each board 12. Each optical backplane 11 and any board 12 implement an optical signal connection through the first optical connector 13 and the second optical connector 14. Optionally, the first optical connector (or the second optical connector) may be various types of optical connectors such as an MT optical fiber connector, a multi-core multi-channel plug-in (MPO) optical fiber connector, or an LC-type optical fiber connector.

In FIG. 1 and FIG. 2, an example in which the first optical connector 13 is fastened to a side surface of a side that is of the optical backplane 11 and that is close to the board 12 is used for illustration. As shown in FIG. 3 and FIG. 4, the first optical connector 13 may alternatively be disposed at an edge that is of a surface of the optical backplane 11 and that is close to the board 12. A position of the first optical connector 13 may be determined based on an actual requirement. This is not limited herein. In addition, in FIG. 1 and FIG. 2, an example in which the optical backplane 11 is connected to the board 12 through two first optical connectors 13 and two second optical connectors 14 is used for illustration. In FIG. 3 and FIG. 4, an example in which the optical backplane 11 is connected to the board 12 through one first optical connector 13 and one second optical connector 14 is used for illustration. During specific implementation, quantities of first optical connectors 13 and second optical connectors 14 between the optical backplane 11 and the board 12 may be set based on an actual requirement. This is not limited herein.

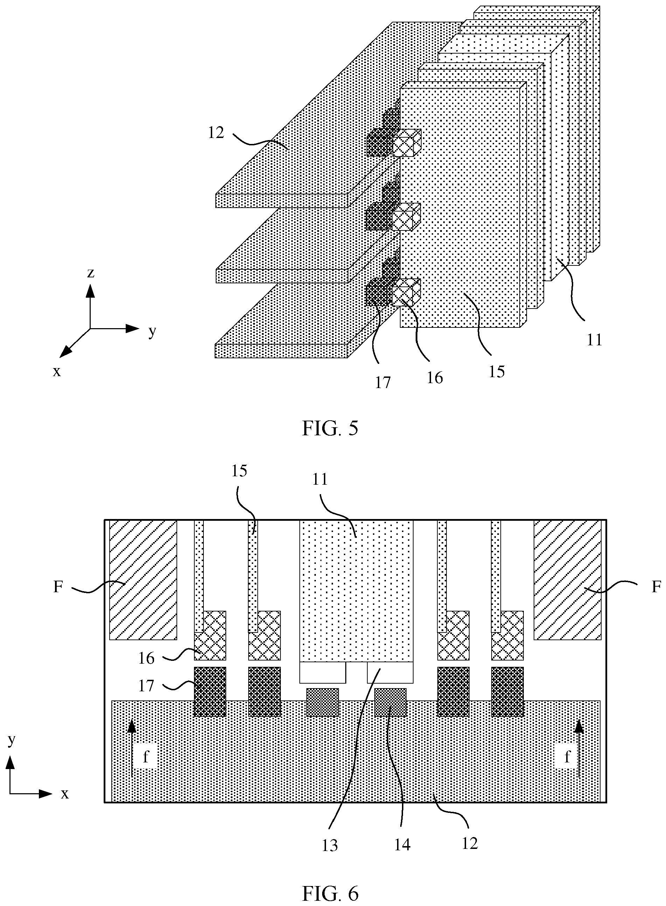

FIG. 5 is a schematic diagram of another three-dimensional structure of an optical backplane interconnection apparatus according to an embodiment of this application. FIG. 6 is a top view of the schematic diagram of a three-dimensional structure shown in FIG. 5. As shown in FIG. 5 and FIG. 6, the board is a service processing board. The optical backplane interconnection apparatus in this embodiment of this application may further include at least one cross-connect board 15. Each cross-connect board 15 is located on a side that is of any board 12 and that faces the optical backplane 11, and each cross-connect board 15 is orthogonal to any board 12. Each cross-connect board 15 is pluggablely connected to any board 12. In other words, the cross-connect board 15 and the optical backplane 11 are located on a same side of the board 12, and the cross-connect board 15 and the optical backplane 11 are disposed in parallel. In this way, the optical backplane interconnection apparatus can process an electrical service while processing an optical service, to implement an optical-electrical integrated architecture. In addition, the board 12 may be connected to the cross-connect board 15 and the optical backplane 11 on a same side surface, so that positions of various connectors on the board 12 can be conveniently determined, and the optical backplane 11 or cross-connect board 15 can be easily replaced.

During specific implementation, the cross-connect board 15 may receive an electrical-layer service transmitted by the board 12, and perform cross scheduling on the received electrical-layer service. In this embodiment of this application, the optical backplane 11 and the cross-connect board 15 are disposed in the optical backplane interconnection apparatus, so that the optical backplane interconnection apparatus can have functions of processing the optical service and the electrical service.

Optionally, in the optical backplane interconnection apparatus in this embodiment of this application, there may be one or more cross-connect boards 15. A quantity of cross-connect boards 15 may be set based on an actual requirement. This is not limited herein.

Still refer to FIG. 5 and FIG. 6. In a possible implementation, the optical backplane interconnection apparatus may include a plurality of cross-connect boards 15. The cross-connect boards 15 are distributed on two sides of the optical backplane 11 in the optical backplane interconnection apparatus. In other words, the optical backplane 11 may be located at a middle position. Optionally, a quantity of cross-connect boards 15 in the optical backplane interconnection apparatus may be an even number. The cross-connect boards 15 may be symmetrically distributed on two sides of the optical backplane 11 in the optical backplane interconnection apparatus.

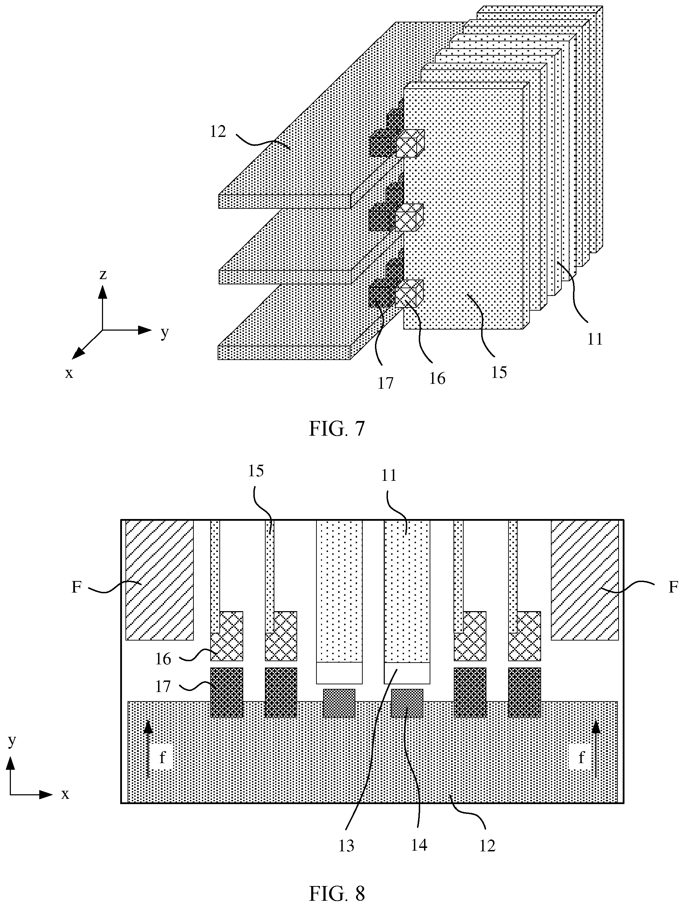

FIG. 7 is a schematic diagram of another three-dimensional structure of an optical backplane interconnection apparatus according to an embodiment of this application. FIG. 8 is a top view of the schematic diagram of a three-dimensional structure shown in FIG. 7. In FIG. 5 and FIG. 6, an example in which one optical backplane 11 is disposed in the optical backplane interconnection apparatus is used for illustration. The cross-connect boards 15 in the optical backplane interconnection apparatus are distributed on the two sides of the optical backplane 11. As shown in FIG. 7 and FIG. 8, a plurality of optical backplanes 11 may alternatively be disposed in the optical backplane interconnection apparatus. In FIG. 7 and FIG. 8, an example in which two optical backplanes 11 are disposed in the optical backplane interconnection apparatus is used. A quantity of optical backplanes 11 may be set based on an actual requirement. The cross-connect boards 15 in the optical backplane interconnection apparatus may be distributed on two sides of each optical backplane 11.

Certainly, during specific implementation, the plurality of cross-connect boards in the optical backplane interconnection apparatus may alternatively be distributed on a same side of the at least one optical backplane. This is not limited herein.

During specific implementation, as shown in FIG. 5 and FIG. 6, a first electrical connector 16 is disposed on a side that is of each cross-connect board 15 and that is close to the board 12. A second electrical connector 17 is disposed on a surface of each board 12. Each cross-connect board 15 and any board 12 implement an electrical signal connection through the first electrical connector 16 and the second electrical connector 17. To facilitate a pluggable connection between the cross-connect board 15 and the board 12, a spring plate may be disposed on the first electrical connector 16, and a contact matching the spring plate may be disposed on the second electrical connector 17, or a contact may be disposed on the first electrical connector 16, and a spring plate matching the contact may be disposed on the second electrical connector 17. In this way, the first electrical connector 16 can be connected to the second electrical connector 17 by using the contact and the spring plate. Certainly, the first electrical connector 16 may alternatively be connected to the second electrical connector 17 in another manner. This is not limited herein.

In FIG. 5 and FIG. 6, an example in which the first electrical connector 16 is fastened to an edge that is of a surface of the cross-connect board 15 and that is close to the board 12 is used for illustration. During specific implementation, the first electrical connector 16 may alternatively be disposed on a side surface of a side that is of the cross-connect board 15 and that is close to the board 12. A position of the first electrical connector 16 may be determined based on an actual requirement. This is not limited herein.

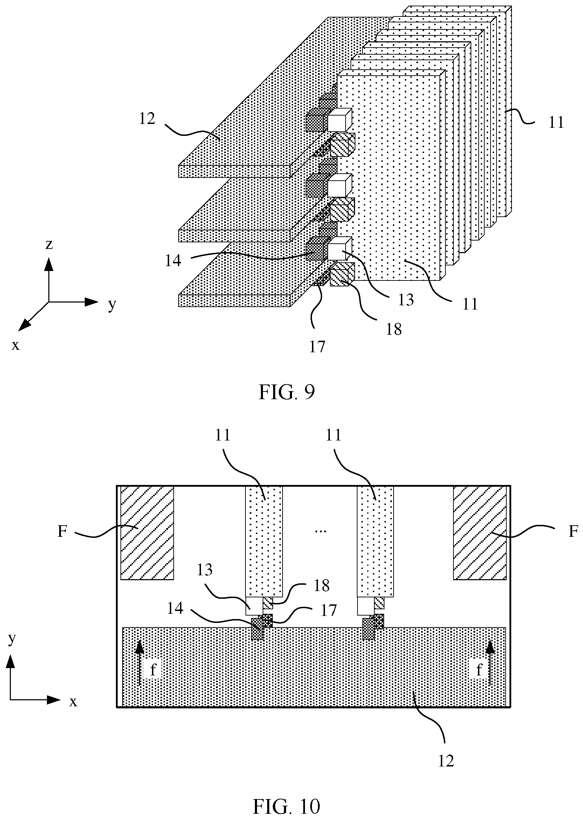

FIG. 9 is a schematic diagram of another three-dimensional structure of an optical backplane interconnection apparatus according to an embodiment of this application. FIG. 10 is a top view of the schematic diagram of a three-dimensional structure shown in FIG. 9. As shown in FIG. 9 and FIG. 10, in a possible implementation, an electrical signal transmission module (not shown in the figure) may be integrated into the optical backplane 11. A first optical connector 13 and a third electrical connector 18 are disposed on a side that is of each optical backplane 11 and that is close to the board 12. A second optical connector 14 and a second electrical connector 17 are disposed on a surface of each board 12. The optical backplane 11 and the board 12 implement an optical signal connection through the first optical connector 13 and the second optical connector 14. The optical backplane 11 and the board 12 implement an electrical signal connection through the third electrical connector 18 and the second electrical connector 17.

In this embodiment of this application, the electrical signal transmission module is integrated into the optical backplane 11, and an optical connector and an electrical connector are respectively disposed on the optical backplane 11 and a service transmission board 12, so that the optical backplane 11 integrates functions of transmitting an optical signal and an electrical signal. This can omit the cross-connect board in the optical backplane interconnection apparatus and reduce space occupied by the optical backplane interconnection apparatus. In addition, because the cross-connect board is omitted, a small quantity of components may be disposed on a side surface of the board 12. This can increase an air amount and help improve heat dissipation effect of each component in a communication device.

Still refer to FIG. 9 and FIG. 10. In each board 12, the second optical connector 14 and the second electrical connector 17 are respectively located on different surfaces of the board 12. In this way, space of an upper surface and a lower surface of the board 12 can be fully used, and positions of the corresponding first optical connector 13 and the corresponding third electrical connector 18 on the optical backplane 11 are more easily determined. This facilitates a pluggable connection between the optical backplane 11 and the board 12. Certainly, when space of the optical backplane 11 and space of the board 12 are sufficient, the second optical connector 14 and the second electrical connector 17 may alternatively be disposed on a same surface of the board 12, that is, both are disposed on the upper surface or the lower surface of the board 12.

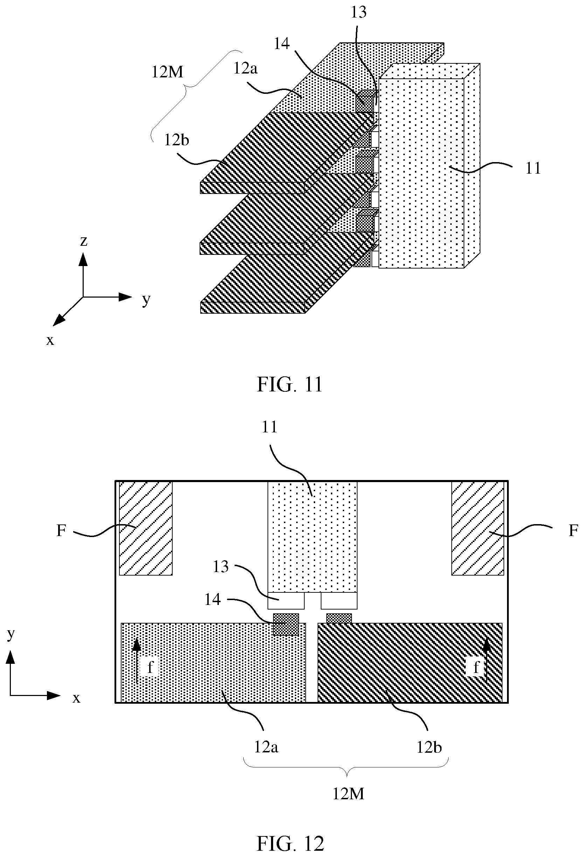

FIG. 11 is a schematic diagram of another three-dimensional structure of an optical backplane interconnection apparatus according to an embodiment of this application. FIG. 12 is a top view of the schematic diagram of a three-dimensional structure shown in FIG. 11. As shown in FIG. 11 and FIG. 12, the optical backplane interconnection apparatus may include the plurality of boards, forming at least one board group 12M. Each board group 12M includes two boards, which are respectively a first board 12a and a second board 12b. In each board group 12M, the first board 12a and the second board 12b are disposed side by side in the first direction (a direction shown by an arrow X in the figure). The first board 12a is connected to the optical backplane 11 at a position close to the second board 12b. The second board 12b is connected to the optical backplane 11 at a position close to the first board 12a. The first direction is the direction perpendicular to the boards.

It can be clearly seen through comparison FIG. 1 with FIG. 11 that, in this embodiment of this application, the first board 12a and the second board 12b are disposed side by side in the first direction, and both the first board 12a and the second board 12b are connected to the optical backplane 11 at a position close to the middle, so that a quantity of boards connected to the optical backplane 11 can be increased, and a quantity of slots of the optical backplane 11 can be increased.

In each board group 12M, the first board 12a is provided with a second optical connector 14 at the position close to the second board 12b, and the second board 12b is provided with a second optical connector 14 at the position close to the first board 12a. The optical backplane 11 is provided with two first optical connectors 13 at a position corresponding to each board group 12M. One first optical connector 13 is connected to the second optical connector 14 of the first board 12a. The other first optical connector 13 is connected to the second optical connector 14 of the second board 12b.

The optical backplane interconnection apparatus in this embodiment of this application may be used in a communication device. Usually, a fan F may be disposed in the communication device, to reduce temperature of each component in the communication device. An air direction formed by the fan F may be shown by an arrow f in the figure. Second optical connectors 14 in the board group 12M are concentrated at a middle position, so that first optical connectors 13 on the optical backplane 11 can also be concentrated. In this way, a width of the optical backplane 11 in the first direction can be narrow, and space occupied by the optical backplane 11 is reduced. Therefore, the optical backplane 11 does not block an air duct. In this way, an air amount can be increased, and heat dissipation effect of each component in the communication device is good.

Still refer to FIG. 11 and FIG. 12. During specific implementation, in each board group 12M, structures of the first board 12a and the second board 12b may be the same. For example, lines or modules in the first board 12a and the second board 12b may be disposed at a same position, and second optical connectors 14 on surfaces of the first board 12a and the second board 12b may be disposed at a same position. In this way, the first board 12a and the second board 12b can share an accessory, and accessory processing costs can be reduced. When the board in each board group 12M is connected to the optical backplane 11, the first board 12a may be inserted in an upward manner, and the second board 12b may be inserted in an inverse manner. That the first board 12a is inserted in an upward manner may be understood as that the second optical connector 14 connected to the optical backplane 11 is disposed on an upper surface of the first board 12a. That the second board 12b is inserted in an inverse manner may be understood as that the second optical connector 14 connected to the optical backplane 11 is disposed on a lower surface of the second board 12b.

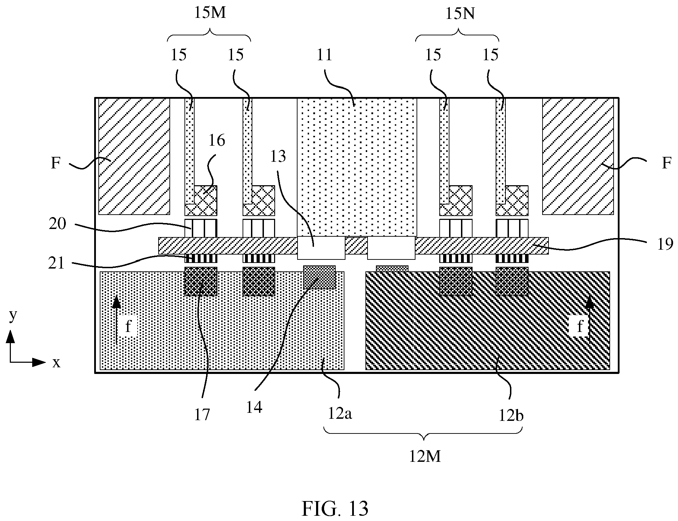

FIG. 13 is a schematic diagram of a top view of a structure of an optical backplane interconnection apparatus according to an embodiment of this application. As shown in FIG. 13, the board is a service processing board. The optical backplane interconnection apparatus in this embodiment of this application may further include at least two cross-connect boards, which are grouped into a first cross-connect board group 15M and a second cross-connect board group 15N. The first cross-connect board group 15M includes at least one cross-connect board 15, and the second cross-connect board group 15N includes at least one cross-connect board 15. Each cross-connect board 15 is located on a side that is of the board and that faces the optical backplane 11, and each cross-connect board 15 is orthogonal to any board. The first cross-connect board group 15M and the second cross-connect board group 15N are respectively located on two sides of the optical backplane 11. In each board group 12M, the first board 12a is pluggablely connected to the cross-connect board 15 in the first cross-connect board group 15M, and the second board 12b is pluggablely connected to the cross-connect board 15 in the second cross-connect board group 15N.

In other words, each cross-connect board 15 and the optical backplane 11 in the optical backplane interconnection apparatus are located on a same side of the board, and each cross-connect board 15 and the optical backplane 11 are disposed in parallel, so that the board can be connected to each cross-connect board 15 and the optical backplane 11 on the same side. In this way, positions of various connectors on the board can be conveniently determined, and the optical backplane 11 or the cross-connect board 15 can be easily replaced. During specific implementation, the cross-connect board 15 may receive an electrical-layer service transmitted by the board 12, and perform cross scheduling on the received electrical-layer service. In this embodiment of this application, the optical backplane 11 and the cross-connect board 15 are disposed in the optical backplane interconnection apparatus, so that the optical backplane interconnection apparatus can have functions of processing the optical service and the electrical service.

Still refer to FIG. 13. In some embodiments of this application, the optical backplane interconnection apparatus may further include an electrical backplane 19 located between the board and the optical backplane 11. Each cross-connect board 15 is located on a side that is of the electrical backplane 19 and that is away from the board. The electrical backplane 19 is pluggablely connected to the first board 12a and the second board 12b in each board group 12M. The electrical backplane 19 is pluggablely connected to each cross-connect board 15 in the first cross-connect board group 15M, and the electrical backplane 19 is pluggablely connected to each cross-connect board 15 in the second cross-connect board group 15N. In this embodiment of this application, the electrical backplane 19 is disposed, a surface of one side of the electrical backplane 19 is connected to the first board 12a and the second board 12b, and a surface of the other side of the electrical backplane 19 is connected to each cross-connect board 15 in the first cross-connect board group 15M and the second cross-connect board group 15N, so that each cross-connect board 15 in the first cross-connect board group 15M can be electrically connected to each cross-connect board 15 in the second cross-connect board group 15N. In this way, an electrical signal can be transmitted between any two cross-connect boards 15 in the first cross-connect board group 15M and the second cross-connect board group 15N.

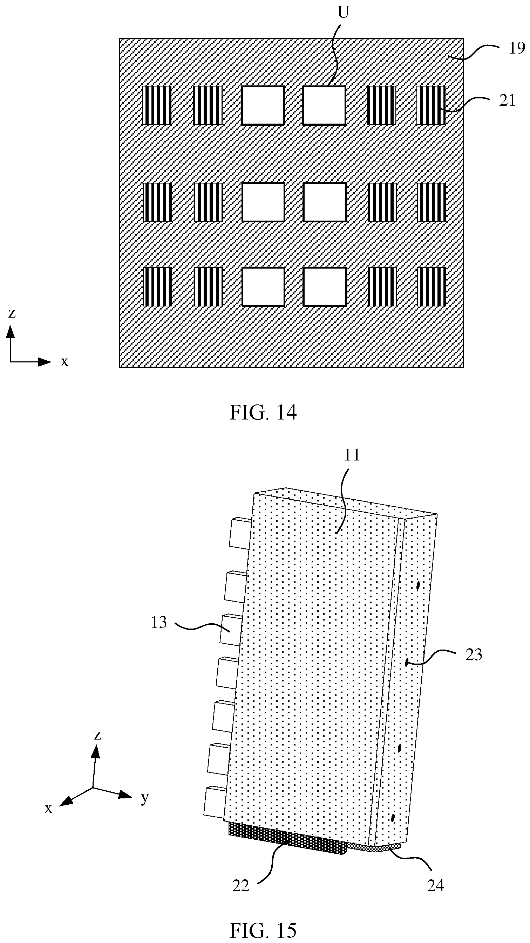

FIG. 14 is a schematic diagram of a planar structure of an electrical backplane according to an embodiment of this application. With reference to FIG. 13 and FIG. 14, the electrical backplane 19 is provided with a plurality of openings U respectively corresponding to positions of first optical connectors 13 on the optical backplane 11. The first optical connector 13 passes through the opening U at a corresponding position and is connected to the second optical connector 14. The electrical backplane 19 is provided with the plurality of openings U, so that each first optical connector 13 on the optical backplane 11 can be connected to the second optical connector 14 after passing through the opening U. In this way, the electrical backplane 19 can be disposed at a position between the optical backplane 11 and the board, and space in the optical backplane interconnection apparatus can be appropriately used. In addition, the electrical backplane 19 does not affect a position of the optical backplane 11. This ensures that the optical backplane 11 can be pluggablely connected to the board.

Still refer to FIG. 13. In a possible implementation, a first electrical connector 16 is disposed on a side that is of each cross-connect board 15 and that is close to the board. A second electrical connector 17 is disposed on a surface of each board. A fourth electrical connector 20 is disposed on a side that is of the electrical backplane 19 and that is close to the cross-connect board 15. A fifth electrical connector 21 is disposed on a side that is of the electrical backplane 19 and that is close to the board. The electrical backplane 19 and the cross-connect board 15 implement an electrical signal connection through the first electrical connector 16 and the fourth electrical connector 20. The electrical backplane 19 and the board implement an electrical signal connection through the second electrical connector 17 and the fifth electrical connector 21.

To facilitate a pluggable connection between the cross-connect board 15 and the electrical backplane 19, a spring plate may be disposed on the first electrical connector 16, and a contact matching the spring plate may be disposed on the fourth electrical connector 20, or a contact may be disposed on the first electrical connector 16, and a spring plate matching the contact may be disposed on the fourth electrical connector 20. In this way, the first electrical connector 16 can be connected to the fourth electrical connector 20 by using the spring plate and the contact. Certainly, the first electrical connector 16 may alternatively be connected to the fourth electrical connector 20 in another manner. This is not limited herein.

To facilitate a pluggable connection between the board and the electrical backplane 19, a spring plate may be disposed on the second electrical connector 17, and a contact matching the spring plate may be disposed on the fifth electrical connector 21, or a contact may be disposed on the second electrical connector 17, and a spring plate matching the contact may be disposed on the fifth electrical connector 21. In this way, the second electrical connector 17 can be connected to the fifth electrical connector 21 by using the spring plate and the contact. Certainly, the second electrical connector 17 may alternatively be connected to the fifth electrical connector 21 in another manner. This is not limited herein.

FIG. 15 is a schematic diagram of a three-dimensional structure of an optical backplane according to an embodiment of this application. As shown in FIG. 15, the optical backplane interconnection apparatus in this embodiment of this application may further include a subrack (not shown in the figure). The subrack is provided with a slot rail. The optical backplane 11 is provided with a sliding rail 22 matching the slot rail. In this way, the optical backplane 11 can be conveniently inserted into the subrack to be connected to the board, and the optical backplane 11 can be easily removed from the subrack. To facilitate removal of the optical backplane 11, a pull ring 24 may be disposed on a side surface of the optical backplane 11. During specific implementation, a wrench or another component may also be used to replace the pull ring 24.

In addition, the optical backplane interconnection apparatus may further include at least one fastener 23. The fastener 23 is configured to detachably fasten the optical backplane 11 to the subrack. Optionally, the optical backplane 11 may be provided with a through hole. The fastener 23 may pass through the optical backplane 11 and be fastened to the subrack, so that the optical backplane 11 is fastened to the subrack, and the optical backplane 11 is prevented from falling off in a processing or transportation process. When the optical backplane 11 needs to be replaced, the fastener 23 may be detached, so that the optical backplane 11 can be smoothly removed. This ensures that the optical backplane 11 can be smoothly replaced. For example, the fastener 23 may be a captive screw, a screw rod, or the like.

Based on a same technical concept, an embodiment of this application further provides a communication device. The communication device may include any one of the foregoing optical backplane interconnection apparatuses and a housing. The communication device may be an optical communication device, a router, a switch, a server, or the like. In the optical backplane interconnection apparatus, the optical backplane is pluggablely connected to the board. Therefore, when the optical backplane is faulty, the optical backplane can be replaced separately without a need to replace an entire cabinet. The optical backplane interconnection apparatus has a flexible structure and high reliability. Therefore, the communication device including the optical backplane interconnection apparatus also has a flexible structure and high reliability.

Although preferred embodiments of this application are described, persons skilled in the art can make changes and modifications to these embodiments after they learn of a basic inventive concept. Therefore, the appended claims are intended to be construed as including the preferred embodiments and all changes and modifications that fall within the scope of this application.

Clearly, persons skilled in the art can make various modifications and variations to embodiments of this application without departing from the spirit and scope of embodiments of this application. In this case, this application is intended to cover these modifications and variations of embodiments of this application provided that they fall within the scope of protection defined by the following claims of this application and their equivalent technologies.

## Claims

1. An optical backplane interconnection apparatus, comprising at least one optical backplane and at least one board, wherein
each optical backplane is orthogonal to any board, a side surface of each optical backplane is disposed opposite to a side surface of any board, and all the boards are located on a same side of any optical backplane; and
each optical backplane is pluggablely connected to any board.

2. The optical backplane interconnection apparatus according to claim 1, wherein the optical backplane interconnection apparatus comprises a plurality of boards arranged in a first direction, and the first direction is a direction perpendicular to the boards.

3. The optical backplane interconnection apparatus according to claim 1, wherein the optical backplane interconnection apparatus comprises a plurality of optical backplanes arranged in a second direction, and the second direction is a direction perpendicular to the optical backplanes.

4. The optical backplane interconnection apparatus according to any one of claims 1 to 3, wherein a first optical connector is disposed on a side that is of each optical backplane and that is close to the board, and a second optical connector is disposed on a surface of each board; and
each optical backplane and any board implement an optical signal connection through the first optical connector and the second optical connector.

5. The optical backplane interconnection apparatus according to any one of claims 1 to 4, wherein the board is a service processing board;
the optical backplane interconnection apparatus further comprises at least one cross-connect board;
each cross-connect board is located on a side that is of any board and that faces the optical backplane, and each cross-connect board is orthogonal to any board; and
each cross-connect board is pluggablely connected to any board.

6. The optical backplane interconnection apparatus according to claim 5, wherein the optical backplane interconnection apparatus comprises a plurality of cross-connect boards; and
the plurality of cross-connect boards in the optical backplane interconnection apparatus are distributed on one side or two sides of the at least one optical backplane.

7. The optical backplane interconnection apparatus according to claim 6, wherein a quantity of cross-connect boards in the optical backplane interconnection apparatus is an even number; and
the plurality of cross-connect boards in the optical backplane interconnection apparatus are symmetrically distributed on the two sides of the at least one optical backplane.

8. The optical backplane interconnection apparatus according to any one of claims 5 to 7, wherein a first electrical connector is disposed on a side that is of each cross-connect board and that is close to the board, and a second electrical connector is disposed on a surface of each board; and
each cross-connect board and any board implement an electrical signal connection through the first electrical connector and the second electrical connector.

9. The optical backplane interconnection apparatus according to any one of claims 1 to 8, wherein an electrical signal transmission module is integrated into the optical backplane;
a first optical connector and a third electrical connector are disposed on a side that is of each optical backplane and that is close to the board;
a second optical connector and a second electrical connector are disposed on a surface of each board; and
the optical backplane and the board implement an optical signal connection through the first optical connector and the second optical connector, and the optical backplane and the board implement an electrical signal connection through the third electrical connector and the second electrical connector.

10. The optical backplane interconnection apparatus according to claim 9, wherein in each board, the second optical connector and the second electrical connector are respectively located on different surfaces of the board.

11. The optical backplane interconnection apparatus according to any one of claims 1 to 4, wherein the optical backplane interconnection apparatus comprises the plurality of boards, forming at least one board group;
each board group comprises two boards, which are respectively a first board and a second board; and
in each board group, the first board and the second board are disposed side by side in the first direction, the first board is connected to the optical backplane at a position close to the second board, the second board is connected to the optical backplane at a position close to the first board, and the first direction is the direction perpendicular to the boards.

12. The optical backplane interconnection apparatus according to claim 11, wherein the board is a service processing board;
the optical backplane interconnection apparatus further comprises at least two cross-connect boards, which are grouped into a first cross-connect board group and a second cross-connect board group, the first cross-connect board group comprises at least one cross-connect board, and the second cross-connect board group comprises at least one cross-connect board;
each cross-connect board is located on a side that is of the board and that faces the optical backplane, and each cross-connect board is orthogonal to any board;
the first cross-connect board group and the second cross-connect board group are respectively located on two sides of the optical backplane; and
in each board group, the first board is pluggablely connected to the cross-connect board in the first cross-connect board group, and the second board is pluggablely connected to the cross-connect board in the second cross-connect board group.

13. The optical backplane interconnection apparatus according to claim 12, further comprising an electrical backplane located between the board and the optical backplane, wherein each cross-connect board is located on a side that of the electrical backplane and that is away from the board;
the electrical backplane is pluggablely connected to the first board and the second board in each board group; and
the electrical backplane is pluggablely connected to each cross-connect board in the first cross-connect board group, and the electrical backplane is pluggablely connected to each cross-connect board in the second cross-connect board group.

14. The optical backplane interconnection apparatus according to claim 13, wherein in each board group, the first board is provided with a second optical connector at the position close to the second board, and the second board is provided with a second optical connector at the position close to the first board;
the optical backplane is provided with two first optical connectors at a position corresponding to each board group, one first optical connector is connected to the second optical connector of the first board, and the other first optical connector is connected to the second optical connector of the second board;
the electrical backplane is provided with a plurality of openings respectively corresponding to positions of first optical connectors on the optical backplane; and
the first optical connector passes through the opening at a corresponding position and is connected to the second optical connector.

15. The optical backplane interconnection apparatus according to claim 13, wherein a first electrical connector is disposed on a side that is of each cross-connect board and that is close to the board, and a second electrical connector is disposed on a surface of each board;
a fourth electrical connector is disposed on a side that is of the electrical backplane and that is close to the cross-connect board, and a fifth electrical connector is disposed on a side that is of the electrical backplane and that is close to the board; and
the electrical backplane and the cross-connect board implement an electrical signal connection through the first electrical connector and the fourth electrical connector, and the electrical backplane and the board implement an electrical signal connection through the second electrical connector and the fifth electrical connector.

16. The optical backplane interconnection apparatus according to any one of claims 1 to 15, further comprising a subrack, wherein
the subrack is provided with a slot rail, and the optical backplane is provided with a sliding rail matching the slot rail.

17. The optical backplane interconnection apparatus according to claim 16, further comprising at least one fastener, wherein
the fastener is configured to detachably fasten the optical backplane to the subrack.

18. A communication device, comprising the optical backplane interconnection apparatus according to any one of claims 1 to 17 and a housing.
